# EUROPÄISCHE PATENTSCHRIFT

(11) **EP 0 712 265 B1**
(45) Veröffentlichungstag und Bekanntmachung des Hinweises auf die Patenterteilung: **02.02.2000**
(21) Anmeldenummer: 95117201.4
(22) Anmeldetag: 02.11.1995
(51) Int. Cl.: H05K 5/00

(54) **Baugruppe**
Electronic assembly
Assemblage électronique

(30) Priorität: 08.11.1994 DE 4439471
(43) Veröffentlichungstag der Anmeldung: 15.05.1996
(73) Patentinhaber: TEMIC TELEFUNKEN microelectronic GmbH, 74072 Heilbronn (DE)
(72) Erfinder: Baur, Richard, D-85276 Pfaffenhofen (DE); Hora, Peter, D-86529 Schrobenhausen (DE); Wetzel, Guido, D-86633 Neuburg (DE); Wöhrl, Alfons, D-86523 Schrobenhausen (DE)
(74) Vertreter: Maute, Hans-Jürgen, Dipl.-Ing.

(56) Entgegenhaltungen:
- EP-A- 0 359 606
- DE-U- 9 113 111
- US-A- 4 993 956
- PATENT ABSTRACTS OF JAPAN vol. 018 no. 230 (E-1542) ,26.April 1994 & JP-A-06 021666 (FUJITSU LTD;OTHERS: 01) 28.Januar 1994,

## Beschreibung

Die Erfindung betrifft eine Baugruppe nach dem Oberbegriff des Anspruchs 1.

Aus dem Dokument EP-A-0 359 606 ist eine Baugruppe bekannt, die aus einem Gehäuse, aus Steckereinheiten mit Anschlußstiften und aus einer mit Leitbahnen versehenen Leiterplatte zu Aufnahme von Bauelementen besteht und bei der die Steckereinheit einstückig mit dem Gehäuse ausgebildet ist und die Anschlußstifte direkt auf die Leiterplatte geführt sind. Nachteilig hierbei ist, daß die Verbindungskontakte mit der gedruckten Schaltung verbunden werden müssen, wozu zusätzliche Arbeitsschritte notwendig sind.

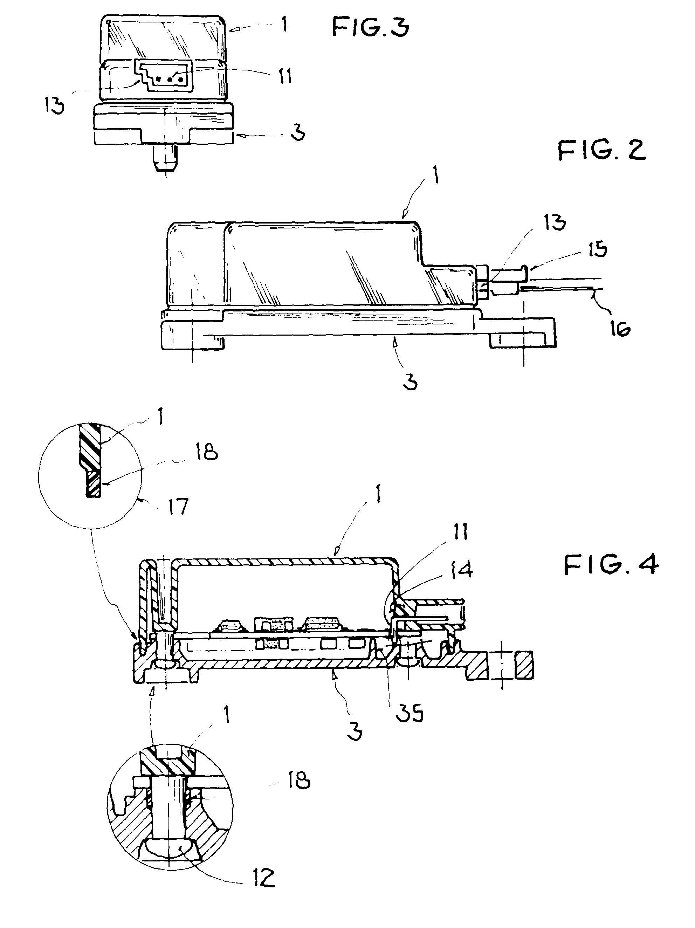

Eine weitere Baugruppe, in diesem Fall als elektrisches Schaltgerät ausgeführt, beschreibt die Offenlegungsschrift DE 32 48 715 A1. Als Maßnahme, um ein feuchtigkeitsdichtes Gehäuse zu realisieren, das beispielsweise zur Aufnahme von Zündanlagen, Kraftstoffeinspritzanlagen, Antiblockiersystemen oder Getriebesteuerungen in Kraftfahrzeugen geeignet ist, werden u.a. Steckeranschlüsse 18 bereits beim Herstellprozeß durch Umgießen mit Kunststoff in das Gehäuse integriert (Fig. 2, 3). Dadurch entfallen die bei einem separat montierten Stecker notwendigen Maßnahmen zur Abdichtung. Nachteilig hierbei ist, daß die Steckeranschlüsse mittels Verbindungsmittel 17, beispielsweise Bonddrähten, mit elektrischen Schaltelementen 16 verbunden werden müssen, wozu zusätzliche Arbeitsschritte notwendig sind.

Es ist deshalb Aufgabe der vorliegenden Erfindung, eine Baugruppe anzugeben, bei der die Anschlußstifte der Baugruppe direkt und mit wenigen Arbeitsschritten mit einer Leiterplatte verbunden werden.

Hierzu sind gemäß Patentanspruch 1 auf der Leiterplatte Kontaktflächen angeordnet, und eine Kontaktierung zwischen den Kontaktflächen und als Federsteckerpins ausgeführten Anschlußstiften der Steckereinheit erfolgt durch Anpressen der Federsteckerpins auf die Kontaktflächen.

Gemäß Patentanspruch 2 weisen die Anschlußstifte eine pyramidenförmige Spitze auf und auf der Leiterplatte sind Lötaugen angeordnet, wobei die Anschlußstifte einen angemessen größeren Durchmesser als die Lötaugen aufweisen. Ein Kontakt erfolgt durch Einpressen der Anschlußstifte in die Lötaugen.

Die Vorteile der Erfindung bestehen insbesondere darin, daß kein zusätzlicher Arbeitsschritt notwendig ist, um eine galvanische Verbindung zwischen den Anschlußstiften der Steckereinheit und Leitbahnen der Leiterplatte oder darauf angeordneten Bauelementen herzustellen.

Die Unteransprüche beschreiben vorteilhafte Ausgestaltungen und Weiterbildungen der Erfindung.

Nach Anspruch 3 enthält die Steckereinheit Versteifungsmittel, die verhindern, daß die Federsteckerpins beim Andrücken auf die Kontaktflächen der Leiterplatte ausweichen oder zurückfedern.

Nach Anspruch 4 sind am Gehäuse und an der Leiterplatte Justiermittel vorhanden, die bewirken, daß die Federstecker pins der Steckereinheit direkt auf die Kontaktflächen der Leiterplatte geführt werden. Die Federsteckerpins stellen dort durch Anpressen den Kontakt her.

Nach Anspruch 5 werden die in Anspruch 4 beschriebenen Justiermittel auch als Verbindungsmittel zwischen Gehäuse und Leiterplatte bzw. zwischen mehreren Gehäuseteilen eingesetzt.

Nach Anspruch 6 werden auf die Kontaktflächen der Leiterplatte sog. Lötbumps aufgebracht.

Nach Anspruch 7 ist ein Gehäuseteil als Trägerplatte ausgeführt, der eine umlaufende Nut aufweist, die zur Aufnahme eines als Deckel oder Abdekkung ausgeführten Gehäuseteils dient.

Nach Anspruch 8 kann diese umlaufende Nut ein konisches Profil aufweisen.

Vorteilhaft ist eine Ausgestaltung der Baugruppe nach Anspruch 9, wobei an den Rändern eines Gehäuseteils und in den Verbindungsmitteln eine Zone angeordnet ist, die aus einem anderen, weicheren Material besteht und deren Aufgabe es ist, die Baugruppe gegen äußere Einflüsse wie z. B. Feuchtigkeit oder Staub abzudichten.

Schließlich Können nach Anspruch 10 auch mehrere Steckereinheiten in einem oder mehreren Gehäuseteilen der Baugruppe angeordnet sein.

Vorteilhaft ist, daß als Verbindungsmittel zum Verbinden der einzelnen Gehäuseteile miteinander keine Nieten, Schrauben o.ä. notwendig sind.

Ein erstes Ausführungsbeispiel der Erfindung ist in den Figuren dargestellt und wird im folgenden ausführlich beschrieben. Ein zweites Ausführungsbeispiel wird ebenfalls erläutert.

Es zeigen
- Figur 1:: eine perspektivische Darstellung eines ersten Ausführungsbeispiels einer erfindungsgemäßen Baugruppe, bestehend aus Trägerplatte, Leiterplatte und Abdeckung mit integrierter Steckereinheit,
- Figur 2:: eine Seitenansicht einer fertig montierten Baugruppe,
- Figur 3:: eine Vorderansicht der Baugruppe nach Figur 2 und
- Figur 4:: eine Schnittzeichnung der Baugruppe nach Figur 2.

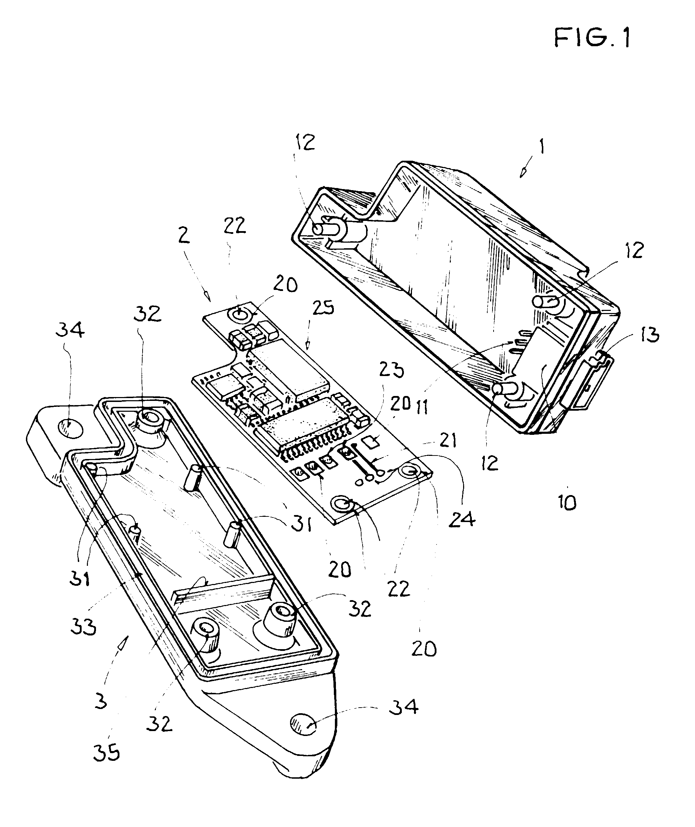

Die Figuren 1 bis 4 zeigen ein erstes Ausführungsbeispiel einer erfindungsgemäßen Baugruppe, bestehend aus einer Trägerplatte 3, einer Leiterplatte 2 und einer Abdeckung 1, vorteilhaft aus einem glasfaserverstärkten Kunststoff, in die eine Steckereinheit 10 integriert ist, die aus dem gleichen Material wie die Abdeckung 1 besteht. Die Steckereinheit 10 enthält Anschlußstifte 11 aus einem gut leitenden und zugleich biegesteifem Metall wie z. B. einer Kupferlegierung und weist eine Kodierung 13 auf, um sicherzustellen, daß ein zugehöriger Stecker 15 mit Signalleitung 16 nicht verpolt werden kann. Als Zapfen ausgebildete Justiermittel 12 gewährleisten eine genaue Ausrichtung der Leiterplatte 2, so daß die Anschlußstifte 11 exakt auf die Kontaktflächen 20 bzw. in Lötaugen 24 positioniert werden können. Sie dienen in Verbindung mit als Buchsen ausgebildeten Justiermitteln 32 der Trägerplatte 3 auch dafür, daß bei der Montage der Rand der Abdeckung 1 ohne Schwierigkeiten in eine umlaufende Nut 33 auf der Trägerplatte 3 eingepaßt werden kann.

Die Zapfen 12 dienen in Verbindung mit den Buchsen 32 ebenfalls dazu, die Gehäuseteile 1 und 3 der Baugruppe zum Schluß der Montage zu verbinden, indem die durch die Buchsen 32 hindurchragenden Zapfen 12 an ihrem Ende beispielsweise mittels Ultraschall zuerst erwärmt und anschließend plattgedrückt werden. Damit dadurch keine Erhebungen am Boden der Trägerplatte 3 entstehen, sind um die Buchsen 32 Aussparungen zur Aufnahme der plattgedrückten Zapfen 12 vorgesehen (Figur 4). Befestigungslöcher 34 dienen dazu, die Baugruppe beispielsweise mittels Nieten oder Schrauben auf einer hierfür vorgesehenen Fläche zu befestigen.

Auf der Leiterplatte 2 sind zur Kontaktierung mit den Anschlußstiften 11 Kontaktflächen 20 angeordnet, die mittels Leitbahnen 21 mit zumeist elektronischen Komponenten 25 verbunden sind. Hierbei sind drei Ausführungsformen der Kontaktflächen 20 vorteilhaft.

Bei einer ersten Ausführungsform, die nich erfindungsgemäß ist, sind die Kontaktflächen 20 als Lötaugen 24 ausgestaltet, die einen größeren Durchmesser als die Anschlußstifte 11 aufweisen. Bei der Montage werden die Anschlußstifte 11 auf bekannte Art und Weise durch die Lötaugen 24 hindurchgeführt und verlötet. Bei einer zweiten, erfindungsgemäßen Ausführungsform sind auf die Kontaktflächen 20 sog. Lötbumps 23 aufgebracht. Zum Kontaktieren werden die vorteilhaft mit einer Spitze versehenen und als Federsteckerpins ausgeführten Anschlußstifte 11, die mittels Versteifungsmitteln 14 (Figur 4) gegen die Abdeckung 1, abgestützt sind, in die Lötbumps 23 eingedrückt. Bei einer dritten, erfindungsgemäßen Ausführungsform der Kontaktflächen 20 sind diese wiederum als Lötaugen 24 ausgestaltet, die aber im Gegensatz zur ersten Ausführungsform einen geringfügig kleineren Durchmesser wie die Anschlußstifte 11 aufweisen. Die Spitzen der wiederum als Federsteckerpins ausgeführten Anschlußstifte 11 sind hierzu pyramidenförmig ausgestaltet. Zum Kontaktieren wird die Leiterplatte 2 mit Hilfe der Justiermittel 12 und 22 gegen die Anschlußstifte 11 gepreßt, wobei die Versteifungsmittel 14 (Figur 4) verhindern, daß die als Federsteckerpins ausgeführten Anschlußstifte 11 ausweichen oder wegfedern. Beim Einpressen wird die runde Form der Lötaugen 24 durch die harten Federsteckerpins 11 leicht eingekerbt. Durch Abstandshalter 31 auf der Trägerplatte 3 und durch die Versteifungsmittel 14 wird ein Trennen der gut leitenden und dauerhaften Kontakte nach dem Zusammenfügen verhindert. Das als dritte. Ausführungsform zum Herstellen einer Kontaktierung beschriebene Verfahren wird auch als "lotfreie Einpreßtechnik" bezeichnet.

Zur elektromagnetischen Abschirmung der sich auf der Leiterplatte 2 befindlichen (elektronischen) Bauelemente 25, wozu auch ein Beschleunigungssensor gehören kann, sind drei Maßnahmen von Vorteil. Als erste Maßnahme sind auf der Ober- und Unterseite der Leiterplatte 2 Kontaktflächen 20 angeordnet und zwar an den Stellen, die mit der Trägerplatte 3 und der Abdeckung 1 in Berührung kommen. Als zweite Maßnahme besteht die Trägerplatte aus einem mechanisch stabilen und elektrisch gut leitenden Metall, vorzugsweise aus Aluminium-Druckguß und weist an den Stellen Abstandshalter 31 und einen Steg 35 auf, die mit den Kontaktflächen 20 auf der Leiterplatte 2 korrespondieren. Als dritte Maßnahme weist die Abdeckung 1 auf ihrer Innenseite entweder eine aufgedampfte Metallisierung oder ein metallisches Einlegeteil auf, dessen Form der der Abdeckung 1 entspricht, wobei sicherzustellen ist, daß nach der Montage die Metallisierung bzw. das Einlegeteil galvanisch mit den Kontaktflächen 20 der Leiterplatte 2 verbunden ist. Alle drei Maßnahmen zusammen gewährleisten die elektromagnetische Verträglichkeit der Baugruppe, indem ab- und eingestrahlte elektromagnetische Wellen von der Metallisierung bzw. dem Einlegeteil aufgefangen, über die Kontaktflächen 20, den Steg 35 und die Abstandshalter 31 der Trägerplatte 3 zugeführt und über durch die Befestigungslöcher 34 hindurchgeführte Schrauben oder Nieten nach Masse hin abgeleitet werden.

Allgemein findet die als erstes Ausführungsbeispiel beschriebene Baugruppe dort Verwendung, wo auf der Leiterplatte 2 empfindliche Bauteile 25 vor Feuchtigkeit und elektromagnetischer Strahlung geschützt werden müssen, etwa wenn die Baugruppe beispielsweise im Motorraum eines Kraftfahrzeugs untergebracht ist.

Bei einem zweiten Ausführungsbeispiel der erfindungsgemäßen Baugruppe handelt es sich um ein einteiliges Gehäuse 1, das zur Aufnahme und gleichzeitig zur Abdeckung einer mit Schaltungsmitteln 25 versehenen Leiterplatte 2 dient. Dadurch, daß die Abdeckung mit Befestigungsmitteln 34 ausgestattet ist, entfällt eine Trägerplatte wie im ersten Ausführungsbeispiel (Figur 1); die aus Gehäuse 1 und Leiterplatte 2 bestehende Baugruppe kann direkt auf einer geeigneten Stelle beispielsweise im Innenraum oder auf einem ebenen Karosserieteil eines Kraftfahrzeugs befestigt werden. Auf der Leiterplatte 2 kann sich dann beispielsweise eine Blinkerschaltung befinden.

Allgemein findet die als zweites Ausführungsbeispiel beschriebene Baugruppe dort ihre Verwendung, wo die sich auf der Leiterplatte befindlichen Schaltungsteile nicht durch ein feuchtigkeitsdichtes Gehäuse geschützt werden müssen oder keine mechanisch stabile Trägerplatte notwendig ist.

## Patentansprüche

1. Baugruppe, insbesondere für Kraftfahrzeuge, mit folgenden Eigenschaften:
a) die Baugruppe besteht aus einem ein- oder mehrteiligen Gehäuse (1, 3), einer Steckereinheit (10) mit Anschlußstiften (11) und einer mit Leitbahnen (21) versehenen Leiterplatte (2) zur Aufnahme von Bauelementen (25),
b) die Steckereinheit (10) ist einstückig mit dem ein- oder mehrteiligen Gehäuse (1, 3) ausgebildet,
c) die Leiterplatte (2) ist derart angeordnet, daß die Anschlußstifte (11) der Steckereinheit (10) direkt auf die Leiterplatte (2) geführt werden,
**gekennzeichnet durch folgende Merkmale:**
d) auf der Leiterplatte (2) sind Kontaktflächen (20) angeordnet und
e) eine Kontaktierung zwischen den Kontaktflächen (20) und als Federstekkerpins ausgeführten Anschlußstiften (11) der Steckereinheit (10) erfolgt durch Anpressen der Federsteckerpins auf die Kontaktflächen (20).

2. Baugruppe, insbesondere für Kraftfahrzeuge, mit folgenden Eigenschaften:
a) die Baugruppe besteht aus einem ein- oder mehrteiligen Gehäuse (1, 3), einer Steckereinheit (10) mit Anschlußstiften (11) und einer mit Leitbahnen (21) versehenen Leiterplatte (2) zur Aufnahme von Bauelementen (25),
b) die Steckereinheit (10) ist einstückig mit dem ein- oder mehrteiligen Gehäuse (1, 3) ausgebildet,
c) die Leiterplatte (2) ist derart angeordnet, daß die Anschlußstifte (11) der Steckereinheit (10) direkt auf die Leiterplatte (2) geführt werden,
**gekennzeichnet durch folgende Merkmale:**
d) die Anschlußstifte (11) weisen eine pyramidenförmige Spitze auf,
e) auf der Leiterplatte (2) sind Lötaugen (24) angeordnet,
f) die Anschlußstifte (11) weisen einen angemessen größeren Durchmesser als die Lötaugen (24) auf und
g) ein Kontakt erfolgt durch Einpressen der Anschlußstifte (11) in die Lötaugen (24).

3. Baugruppe nach Anspruch 1, dadurch gekennzeichnet, daß in der Steckereinheit (10) Versteifungsmittel (14) angeordnet sind, um ein Ausweichen oder Zurückfedern der Federsteckerpins (11) beim Andrücken auf die Kontaktflächen (20) zu verhindern.

4. Baugruppe nach Anspruch 1, dadurch gekennzeichnet, daß am Gehäuse (1, 3) und an der Leiterplatte (2) Justiermittel (12, 22, 32) angeordnet sind, die derart zusammenwirken, daß die Federsteckerpins direkt auf die Kontaktflächen (20) der Leiterplatte (2) geführt werden und dort durch Anpressen auf die Kontaktflächen (20) den Kontakt herstellen.

5. Baugruppe nach Anspruch 4, dadurch gekennzeichnet, daß die Justiermittel (12, 22, 32) auch als Verbindungsmittel zwischen Gehäuse (1, 3) und Leiterplatte (2) bzw. zwischen zwei oder mehreren Gehäuseteilen (1, 3) eingesetzt werden.

6. Baugruppe nach Anspruch 1, dadurch gekennzeichnet, daß auf die Kontaktflächen (20) der Leiterplatte (2) sog. Lötbumps (23) aufgebracht werden.

7. Baugruppe nach Anspruch 1 oder 2, dadurch gekennzeichnet, daß eine umlaufende Nut (33) in ein als Trägerplatte ausgeführtes Gehäuseteil (3) zur Aufnahme eines als Deckel oder Abdeckung ausgeführten Gehäuseteils (1) eingebracht ist.

8. Baugruppe nach Anspruch 7, dadurch gekennzeichnet, daß die umlaufende Nut (33) ein konisches Profil aufweist.

9. Baugruppe nach Anspruch 5, dadurch gekennzeichnet, daß an den Rändern (17) eines Gehäuseteils (1) und in den Verbindungsmitteln eine Zone aus einem anderen, weicheren Material (18) angeordnet ist, deren Funktion die Abdichtung der Baugruppe (1, 2, 3) gegen äußere Einflüsse ist.

10. Baugruppe nach einem der Ansprüche 1 oder 2, dadurch gekennzeichnet, daß in der Baugruppe (1, 3) mehrere Steckereinheiten (10) angeordnet sind.

## Claims

1. An electronic assembly, in particular for motor vehicles, having the following properties:
a) the electronic assembly consists of a single or multi-part casing (1, 3), a connector unit (10) including terminal pins (11) and a circuit board (2) provided with conductive tracks (21) for accommodating components (25),
b) the connector unit (10) is constructed unitarily with the single or multi-part casing (1, 3),
c) the circuit board (2) is arranged such that the terminal pins (11) of the connector unit (10) are guided directly onto the circuit board (2),
characterised by the following features:
d) contact surfaces (20) are arranged on the circuit board (2) and
e) contact between the contact surfaces (20) and the terminal pins (11) of the connector unit (10), which are implemented in the form of spring-loaded plug pins, is effected by pressing the spring-loaded plug pins onto the contact surfaces (20).

2. An electronic assembly, in particular for motor vehicles, having the following properties:
a) the electronic assembly consists of a single or multi-part casing (1, 3), a connector unit (10) including terminal pins (11) and a circuit board (2) provided with conductive tracks (21) for accommodating components (25),
b) the connector unit (10) is constructed unitarily with the single or multi-part casing (1, 3),
c) the circuit board (2) is arranged such that the terminal pins (11) of the connector unit (10) are guided directly onto the circuit board (2),
characterised by the following features:
d) the terminal pins (11) have a pyramid-shaped tip,
e) eyelets (24) are arranged on the circuit board (2),
f) the terminal pins (11) have an appropriately larger diameter than the eyelets (24) and
g) contact is effected by pressing the terminal pins (11) into the eyelets (24).

3. An electronic assembly in accordance with Claim 1, characterised in that bracing means (14) are arranged in the connector unit (10) for preventing the spring-loaded plug pins (11) from deflecting or springing back when pressing down on the contact surfaces (20).

4. An electronic assembly in accordance with Claim 1, characterised in that alignment means (12, 22, 32) are arranged on the casing (1, 3) and on the circuit board (2), said alignment means co-operating in such a way that the spring-loaded plug pins are guided directly onto the contact surfaces (20) of the circuit board (2) and establish contact there by pressing on the contact surfaces (20).

5. An electronic assembly in accordance with Claim 4, characterised in that the alignment means (12, 22, 32) are also employed as connecting means between the casing (1, 3) and the circuit board (2) or between two or more parts of the casing (1, 3).

6. An electronic assembly in accordance with Claim 1, characterised in that so-called solder bumps (23) are applied to the contact surfaces (20) of the circuit board (2).

7. An electronic assembly in accordance with Claim 1 or 2, characterised in that a peripheral groove (33) is formed in a part of the casing (3) implemented in the form of a base plate for accommodating another part of the casing (3) implemented in the form of a cover or covering.

8. An electronic assembly in accordance with Claim 7, characterised in that the groove (33) has a conical profile.

9. An electronic assembly in accordance with Claim 5, characterised in that a zone for sealing the electronic assembly (1, 2, 3) from external effects is arranged at the edges (17) of one casing part (1) and in the connecting means, said zone consisting of a different, softer material (18).

10. An electronic assembly in accordance with Claim 1 or 2, characterised in that a plurality of connector units (10) are arranged in the electronic assembly (1, 3).

## Revendications

1. Module, notamment pour véhicules automobiles, présentant les caractéristiques suivantes :
a) le module est constitué par un boîtier (1,3) formé d'un ou de plusieurs éléments, par une unité formant connecteur (10) comportant des broches de raccordement (11) et par une plaquette à circuits imprimés (2), qui est pourvue de voies conductrices (21) et sert à recevoir des composants (25),
b) l'unité formant connecteur (10) est réalisée d'un seul tenant avec le boîtier (1,3) formé d'un ou de plusieurs éléments,
c) la plaquette à circuits imprimés (2) est disposée de telle sorte que les broches de raccordement (11) de l'unité formant connecteur (10) sont dirigées directement sur la plaquette à circuits imprimés (2),
caractérisé par les caractéristiques suivantes :
d) des surfaces de contact (20) sont disposées sur la plaquette à circuits imprimés; et
e) un contact est établi entre les surfaces de contact (20) et les broches de raccordement (11), agencées sous la forme de broches de connexion à ressort, de l'unité formant connecteur (10) au moyen du serrage des broches d'enfichage à ressort contre les surfaces de contact (20).

2. Module, notamment pour véhicules automobiles, présentant les caractéristiques suivantes :
a) le module est constitué par un boîtier (1,3) formé d'un ou de plusieurs éléments, par une unité formant connecteur (10) comportant des broches de raccordement (11) et par une plaquette à circuits imprimés (2), qui est pourvue de voies conductrices (21) et sert à recevoir des composants (25),
b) l'unité formant connecteur (10) est réalisée d'un seul tenant avec le boîtier (1,3) formé d'un ou de plusieurs éléments,
c) la plaquette à circuits imprimés (2) est disposée de telle sorte que les broches de raccordement (11) de l'unité formant connecteur (10) sont dirigées directement sur la plaquette à circuits imprimés (2),
caractérisé par les caractéristiques suivantes :
d) les broches de raccordement (11) possèdent une pointe de forme pyramidale,
e) des oeillets de brasage (24) sont disposés sur la plaquette à circuits imprimés (2),
f) les broches de raccordement (11) possèdent un diamètre correspondant supérieur à celui des oeillets de brasage (24), et
g) un contact est réalisé par enfoncement des broches de raccordement (11) dans les oeillets de brasage (24).

3. Module selon la revendication 1, caractérisé en ce que dans l'unité formant connecteur (10) sont disposés des moyens de rigidification (14) servant à empêcher un écartement ou un rappel élastique des fiches de connexion à ressort (11) lors de leur serrage contre les surfaces de contact (20).

4. Module selon la revendication 1, caractérisé en ce que sur le boîtier (1,3) et sur la plaquette à circuits imprimés (2) sont disposés des moyens d'ajustement (12,22,32) qui coopèrent de telle sorte que les fiches de connexion à ressort sont dirigées directement sur les surfaces de contact (20) de la plaquette à circuits imprimés (2) et y établissent le contact par serrage sur les surfaces de contact (20).

5. Module selon la revendication 4, caractérisé en ce que les moyens d'ajustement (12,22,32) sont insérés également en tant que moyens de liaison entre le boîtier (1,3) et la plaquette à circuits imprimés (2) ou entre deux ou plusieurs parties (1,3) du boîtier.

6. Module selon la revendication 1, caractérisé en ce qu'on appelle des plots de brasure (23) sont déposés sur les surfaces de contact (20) de la plaquette à circuits imprimés (2).

7. Module selon la revendication 1 ou 2, caractérisé en ce qu'une rainure circonférentielle (33) est aménagée dans une partie (30) du boîtier, réalisée sous la forme d'une bague de support, de manière à supporter une partie (1) du boîtier réalisée sous la forme d'un couvercle ou d'un élément de recouvrement.

8. Module selon la revendication 7, caractérisé en ce que la rainure circonférentielle (33) possède un profil conique.

9. Module selon la revendication 5, caractérisé en ce que sur les bords (17) d'une partie (1) du boîtier et dans les moyens de liaison est disposée une zone formée d'un autre matériau plus mou (18), dont la fonction est d'étanchéifier le module (1,2,3) vis-à-vis d'influences extérieures.

10. Module selon l'une des revendications 1 ou 2, caractérisé en ce que plusieurs unités formant connecteurs (1) sont disposées dans le module (1,3).
